# EUROPÄISCHE PATENTSCHRIFT

(11) **EP 3 061 111 B1**
(45) Veröffentlichungstag und Bekanntmachung des Hinweises auf die Patenterteilung: **29.03.2017**
(21) Anmeldenummer: 13820770.9
(22) Anmeldetag: 20.12.2013
(51) Int. Cl.: H01H 33/59, H01H 9/42

(54) **VORRICHTUNG UND VERFAHREN ZUM SCHALTEN EINES GLEICHSTROMES**
APPARATUS AND METHOD FOR SWITCHING A DIRECT CURRENT
DISPOSITIF ET PROCÉDÉ POUR COMMUTER UN COURANT CONTINU

(43) Veröffentlichungstag der Anmeldung: 31.08.2016
(73) Patentinhaber: Siemens Aktiengesellschaft, 80333 München (DE)
(72) Erfinder: ECKEL, Hans-Günter, 18059 Rostock (DE); ERGIN, Dominik, 91083 Baiersdorf (DE); GAMBACH, Herbert, 91080 Uttenreuth (DE); KNAAK, Hans-Joachim, 91054 Erlangen (DE); PHILIPP, Andreas, 90610 Winkelhaid (DE); SCHIERLING, Hubert, 91052 Erlangen (DE)
(86) Internationale Anmeldenummer: PCT/EP2013/077775
(87) Internationale Veröffentlichungsnummer: WO 2015/090464

(56) Entgegenhaltungen:
- WO-A1-2011/050832
- WO-A1-2011/141054
- FR-A1- 2 496 333

## Beschreibung

Vorrichtung und Verfahren zum Schalten eines Gleichstromes Die Erfindung betrifft eine Vorrichtung zum Schalten eines Gleichstromes in einer Hochspannungsleitung mit einer Vielzahl von Schalteinheiten, die unter Ausbildung einer Reihenschaltung in der Hochspannungsleitung angeordnet sind. Jede Schalteinheit umfasst dabei ein Schaltelement sowie einen in einer Parallelschaltung zum Schaltelement angeordneten Überspannungsableiter, dessen Schwellenspannung höher als eine Nennspannung des Schaltelementes ist, wobei die Summe der Nennspannungen der Schaltelemente mindestens einer Betriebsspannung der Hochspannungsleitung entspricht.

Unter Hochspannung werden in diesem Zusammenhang Spannungspotenzialdifferenzen von mindestens 10 kV, beispielsweise gegenüber Erdpotenzial, verstanden.

Eine Vorrichtung dieser Art ist aus der WO 2011/141054 A1 bekannt. Die Schaltelemente gemäß der WO 2011/141054 A1 sind Halbleiterschalter. Um die Durchlassverluste niedrig zu halten, die in der Vorrichtung während eines Normalbetriebes entstehen, ist in Reihe zu den Schalteinheiten mit den Halbleiterschaltern eine weitere Schalteinheit angeordnet, die einen mechanischen Schalter umfasst. Im Normalbetrieb fließt der Strom über den mechanischen Schalter, dessen Verluste klein gegenüber denjenigen der Halbleiterschalter sind. Beim Ausschalten der bekannten Vorrichtung werden zunächst die Halbleiterschalter ausgeschaltet und danach kann der mechanische Schalter ausgelöst werden und den Strom in der Hochspannungsleitung unterbrechen.

Das Dokument WO2011/050832 offenbart eine Vorrichtung gemäß dem Oberbegriff des Anspruchs 1.

Die bekannte Vorrichtung ist zum Einsatz in einer Hochspannungsleitung vorgesehen, die eine Betriebsspannung aufweisen kann, die bis zu mehreren Hundert kV beträgt. Daher muss die bekannte Vorrichtung eine hohe Anzahl an Halbleiterschaltern umfassen, die erst den Strom begrenzen, so dass der mechanische Schalter ausgelöst werden kann. Eine hohe Anzahl an Halbleiterschaltern resultiert jedoch in immer noch hohen Verlusten in der Vorrichtung. Zudem verlängert sich die Schaltzeit der Vorrichtung, wenn die Halbleiterschalter und der mechanische Schalter zeitlich nacheinander schalten. Ferner ergeben sich durch den Einsatz von Halbleiterschaltern hohe Herstellungskosten der Vorrichtung.

Ausgehend vom Stand der Technik besteht die Aufgabe der Erfindung darin, eine artgemäße Vorrichtung vorzuschlagen, die kostengünstig ist und eine Senkung der Durchlassverluste erlaubt.

Die Aufgabe wird dadurch gelöst, dass die Schaltelemente der Vorrichtung mechanische Schalter sind, wobei jeder mechanische Schalter eine Kontaktanordnung mit zwei trennbaren Kontaktstücken umfasst und dazu eingerichtet ist, beim Trennen der Kontaktstücke eine Lichtbogenspannung aufzubauen, deren Betrag höher als die Nennspannung des mechanischen Schalters ist.

Als Nennspannung des mechanischen Schalters ist dabei diejenige Spannung zu verstehen, die der mechanische Schalter dauerhaft isolieren kann. Üblicherweise kann der mechanische Schalter darüber hinaus transiente Spannungsüberhöhungen in der Hochspannungsleitung, die über der Nennspannung liegen, ebenfalls kurzzeitig isolieren.

Soll der Strom in der Hochspannungsleitung geschaltet werden, beispielsweise in einem Fehlerfall, so werden die mechanischen Schalter geschaltet, wobei die Kontaktstücke getrennt werden. Dabei kommt es für gewöhnlich zu der Entstehung eines Lichtbogens zwischen den voneinander getrennten Kontaktstücken. Der mechanische Schalter der erfindungsgemäßen Vorrichtung ist dazu eingerichtet, eine Lichtbogenspannung aufzubauen, deren Betrag höher als dessen Nennspannung ist. Aufgrund dieser Fähigkeit können die mechanischen Schalter in Summe eine Gegenspannung aufbauen, die größer als die Betriebsspannung der Hochspannungsleitung beziehungsweise des Gleichspannungsnetzes ist. Auf diese Weise wird in jeder der Schalteinheiten der Strom vom mechanischen Schalter auf den Parallelzweig mit dem Überspannungsableiter kommutiert und der Lichtbogen erlischt. Die Schwellenspannung des Überspannungsableiters liegt jeweils oberhalb der Nennspannung des mechanischen Schalters, so dass der Strom durch die Vorrichtung insgesamt auf einen zu vernachlässigenden Reststrom durch die Überspannungsableiter begrenzt werden kann. Ferner wird durch die Kommutierung des Stromes auf die Überspannungsableiter ein Wiederzünden einzelner Lichtbögen, das aufgrund unterschiedlicher Löschzeitpunkte auftreten kann, verhindert. Des Weiteren entlastet der Überspannungsableiter den mechanischen Schalter dadurch, dass die induktiv in der Hochspannungsleitung gespeicherte Energie teilweise vom Überspannungsableiter absorbiert wird und nicht vollständig von den einzelnen Lichtbögen absorbiert werden muss. Dies reduziert die Beanspruchung der mechanischen Schalter.

Ein Vorteil der erfindungsgemäßen Vorrichtung ist, dass im Normalbetrieb der Strom in der Hochspannungsleitung über die mechanischen Schalter fließt, wobei die dabei entstehenden Verluste kleiner als bei entsprechenden Halbleiterschaltern sind. Dadurch können Betriebskosten eines die Hochspannungsleitung umfassenden Gleichspannungsnetzes reduziert werden.

Durch die Verwendung der in Reihe geschalteten mechanischen Schalter kann zudem die Schaltzeit gegenüber einer Verwendung eines einzelnen mechanischen Schalters mit einer notwendigerweise langen Isolierstrecke verkürzt werden.

Bei einer Trennung zweier unter Spannung stehender Kontakte in freier Luft entsteht ein Lichtbogen, dessen Lichtbogenspannung je cm Bogenlänge etwa 20 V beträgt. Diese Spannung ist nicht ausreichend, um bei gegebener Höchsttrennstrecke zwischen den Kontaktstücken von wenigen Zentimetern eine zur Löschung des Lichtbogens ausreichende Lichtbogenspannung aufzubauen. Eine Erhöhung der Lichtbogenspannung kann beispielsweise durch Kühlung erreicht werden, beispielsweise mittels eines die Kontaktstücke umströmenden Gases oder Öls. Vorzugsweise weisen die mechanischen Schalter zum Aufbau der Lichtbogenspannung jeweils wenigstens eine Lichtbogen-Löschkammer auf. Die Lichtbogen-Löschkammer kann dabei mehrere parallel zueinander angeordnete Löschbleche umfassen. Der zwischen den Kontaktstücken brennende Lichtbogen kann beispielsweise mittels einer elektromagnetischen Beblasung in Richtung der Löschbleche getrieben werden, so dass der Lichtbogen sich in Teillichtbögen, die zwischen den Löschblechen brennen, aufteilt. Auf diese Weise kann die Lichtbogenspannung erheblich erhöht werden.

Gemäß einer Ausführungsform der Erfindung ist wenigstens eine Auslöseeinheit zum Auslösen des Schalters vorgesehen. Die Auslöseeinheit setzt beispielsweise unter Ausnutzung elektromechanischer Kräfte das Trennen der Kontaktstücke des mechanischen Schalters in Gang, wie es beispielsweise in marktüblichen Bahnschnellschaltern realisiert ist. Besonders geeignet erscheinen hierbei Bahnschnellschalter aus Bahnanwendungen, die über eine Schnellauslösung verfügen, die es erlaubt, die Kontaktstücke innerhalb weniger Millisekunden, bevorzugt weniger als 10 ms, besonders bevorzugt weniger als 5 ms, zu trennen. Übliche Bahnschnellschalter, die hierbei zur Anwendung kommen können, weisen eine Nennspannung von 4 kV und einen DC-Nennstrom von 5 kA. Die Vorrichtung kann beispielsweise zwischen 50 und 200 solcher in Reihe angeordneter Bahnschnellschalter umfassen.

Vorzugsweise umfasst die Vorrichtung wenigstens eine Steuerungsvorrichtung zur Ansteuerung der wenigstens einen Auslöseeinheit. Falls die erfindungsgemäße Vorrichtung mehrere Auslöseeinheiten umfasst, ist die Steuerungsvorrichtung vorzugsweise dazu eingerichtet, die Auslöseeinheiten einzeln anzusteuern. Auf diese Weise können die mechanischen Schalter zum Beispiel in einer vorgegebenen Reihenfolge, jedoch nicht alle gleichzeitig, ausgelöst werden. Somit kann die Gegenspannung in der gesamten Vorrichtung schrittweise angepasst werden. Dies erlaubt eine Stromänderungsrate eines Fehlerstromes variabel einzustellen.

Vorzugsweise beträgt die Nennspannung der mechanischen Schalter zwischen 1 kV und 20 kV.

Gemäß einer weiteren vorteilhaften Ausführungsform der erfindungsgemäßen Vorrichtung sind die Überspannungsableiter Metalloxid-Varistoren. Diese Varistoren zeichnen sich gegenüber anderen Varistoren, beispielsweise Siliziumkarbid-Varistoren, durch einen besonders vorteilhaften Verlauf der Strom-Spannungs-Kennlinie aus.

Gemäß einer weiteren Ausführungsform der erfindungsgemäßen Vorrichtung umfasst die Vorrichtung einen Trennschalter zum Unterbrechen des Gleichstromes. Der Trennschalter ist dabei in Reihe zu den Schalteinheiten angeordnet. Der Trennschalter ist dazu eingerichtet, die Hochspannungsleitung zu unterbrechen und damit Spannungslos zu schalten, sobald die mechanischen Schalter geöffnet und die Lichtbögen gelöscht sind.

Die Schalteinheiten der erfindungsgemäßen Vorrichtung umfassen vorzugsweise ferner jeweils eine Stromanstieg begrenzende Induktivität, die in Reihe zum mechanischen Schalter angeordnet ist.

Bevorzugt umfasst die erfindungsgemäße Vorrichtung eine Messeinrichtung zum Detektieren eines Fehlerstromes in der Hochspannungsleitung. Die Messeinrichtung ist mit der Steuerungsvorrichtung verbunden. Die Messeinrichtung kann beispielsweise dazu vorgesehen sein, den Strom und/oder den Stromanstieg in der Hochspannungsleitung zu erfassen bzw. zu ermitteln. Die Messeinrichtung kann entsprechend der erfassten Messdaten ein Ausgangssignal erzeugen, das an die Steuerungsvorrichtung geleitet werden kann, so dass die Steuerungsvorrichtung das Ausgangssignal der Messeinrichtung in entsprechende Steuersignale umwandeln kann.

Ferner betrifft die Erfindung ein Verfahren zum Schalten des Gleichstromes in einer Hochspannungsleitung und stellt sich die Aufgabe, ein solches Verfahren so auszugestalten, dass es kostengünstig bei geringen Durchlassverlusten durchführbar ist.

Die Aufgabe wird erfindungsgemäß durch ein Verfahren gelöst, bei dem in einer Reihenschaltung angeordnete mechanische Schalter ausgelöst werden, wobei in jedem mechanischen Schalter eine Lichtbogenspannung aufgebaut wird, deren Betrag höher als eine Nennspannung des mechanischen Schalters ist, so dass der Strom in einen parallel zu jedem mechanischen Schalter angeordneten Parallelzweig mit mindestens einem Überspannungsableiter kommutiert wird, dessen Schwellenspannung höher als die Nennspannung des mechanischen Schalters ist.

Ein Vorteil des erfindungsgemäßen Verfahrens ist, dass im Normalbetrieb der Strom in der Hochspannungsleitung über die mechanischen Schalter fließt, wobei die dabei entstehenden Verluste kleiner als bei entsprechenden Halbleiterschaltern sind. Dadurch können Betriebskosten eines die Hochspannungsleitung umfassenden Gleichspannungsnetzes reduziert werden.

Die im Wesentlichen parallel durchgeführte Auslösung der mechanischen Schalter erlaubt in vorteilhafter Weise eine Beschränkung der Schaltzeit. Jeder der mechanischen Schalter kann innerhalb weniger Millisekunden schalten und der Aufbau der erforderlichen Lichtbogenspannung benötigt ebenfalls nur wenige Millisekunden. Dadurch wird ein schnelles und zuverlässiges Schalten von Strömen in Hochspannungsleitungen erreicht.

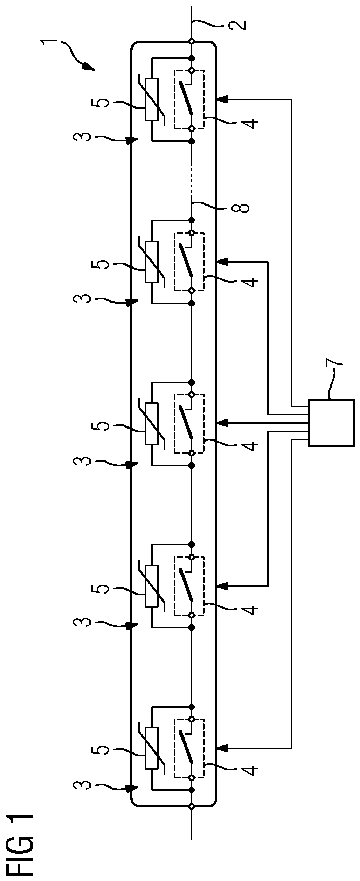

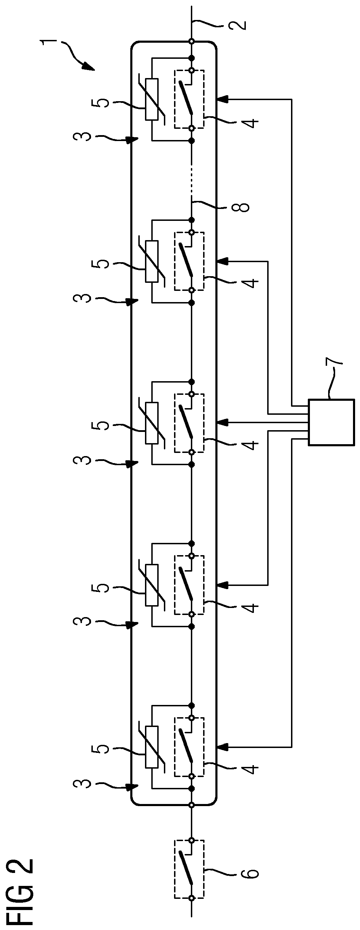

Im Folgenden werden Ausführungsbeispiele der Erfindung anhand von Figuren 1 und 2 näher erläutert.
- Figur 1: zeigt ein erstes Ausführungsbeispiel einer erfindungsgemäßen Vorrichtung in schematischer Darstellung.
- Figur 2: zeigt ein zweites Ausführungsbeispiel der erfindungsgemäßen Vorrichtung in schematischer Darstellung.

Im Einzelnen zeigt die Figur 1 eine Vorrichtung 1 zum Schalten eines Gleichstromes in einer Hochspannungsleitung 2. Die Vorrichtung 1 umfasst eine Reihenschaltung von in Reihe geschalteten Schalteinheiten 3. Jede Schalteinheit 3 umfasst ein Schaltelement, das ein mechanischer Schalter 4 ist. In der schematischen Darstellung der Figur 1 sind fünf Schalteinheiten 3 mit fünf mechanischen Schaltern 4 explizit graphisch dargestellt. Durch einen unterbrochenen Linienabschnitt 8 ist jedoch angedeutet, dass die Vorrichtung 1 darüber hinaus weitere Schalteinheiten umfasst. Die Anzahl der Schalteinheiten 3 richtet sich nach der Betriebsspannung in der Hochspannungsleitung 2 sowie nach den Nennspannungen der mechanischen Schalter 4. Jede Schalteinheit 3 weist ferner einen Metalloxid-Varistor 5, der in einem Parallelzweig zum mechanischen Schalter 4 angeordnet ist.

Wird mittels einer in Figur 1 graphisch nicht dargestellten Messeinrichtung ein Fehlerstrom in der Hochspannungsleitung 2 festgestellt, so generiert eine Steuerungsvorrichtung 7 Steuerungssignale, die die mechanischen Schalter 4 auslösen. Jeder mechanische Schalter 4 verfügt über mechanische Kontaktstücke, die beim Auslösen voneinander getrennt werden. Dabei entsteht zwischen den mechanischen Kontaktstücken der mechanischen Schalter 4 jeweils ein Lichtbogen. Zur Erzeugung einer Lichtbogenspannung, die höher als die Nennspannung der mechanischen Schalter 4 ist, wird im dargestellten Ausführungsbeispiel der Lichtbogen über spezielle Löschbleche geführt, die in den mechanischen Schaltern 4 angeordnet sind. Sobald die Lichtbogenspannung in den mechanischen Schaltern 4 in Summe mindestens der Betriebsspannung an der Hochspannungsleitung 2 entspricht, wird der Strom in den mechanischen Schaltern 4 jeweils auf den Parallelzweig mit den Varistoren 5 kommutiert. Da die Schwellenspannung der Varistoren 5 höher ist als die Nennspannung der mechanischen Schalter 4, wird der Strom insgesamt auf einen kleinen, zu vernachlässigenden Reststrom begrenzt.

In Figur 2 ist ein zweites Ausführungsbeispiel der erfindungsgemäßen Vorrichtung dargestellt. Gleiche und gleichartige Teile weisen in den Figuren 1 und 2 jeweils gleiche Bezugszeichen auf. Zur Vermeidung von Wiederholungen wird daher in der Beschreibung der Figur 2 lediglich auf diejenigen Elemente eingegangen, die das Ausführungsbeispiel der Figur 2 vom Ausführungsbeispiel der Figur 1 unterscheiden.

Eine Vorrichtung 11 gemäß dem Ausführungsbeispiel der Figur 2 unterscheidet sich von der Vorrichtung 1 gemäß dem Ausführungsbeispiel der Figur 1 dadurch, dass in Reihe zu der Reihenschaltung der Schalteinheiten 3 ferner ein Trennschalter 6 angeordnet ist. Der Trennschalter 6 kann, sobald der Strom in der Vorrichtung 11 auf den Reststrom begrenzt worden ist, den Strom in der Hochspannungsleitung 2 unterbrechen und damit die Hochspannungsleitung 2 vollkommen abzuschalten.

### Bezugszeichentabelle

- 1,11: Vorrichtung zum Schalten eines Gleichstromes
- 2: Hochspannungsleitung
- 3: Schalteinheit
- 4: Schaltelement
- 5: Überspannungsableiter
- 6: Trennschalter
- 7: Steuerungsvorrichtung
- 8: Leitungsabschnitt

## Patentansprüche

1. Vorrichtung (1,11) zum Schalten eines Gleichstromes in einer Hochspannungsleitung (2) mit einer Vielzahl von Schalteinheiten (3), die unter Ausbildung einer Reihenschaltung in der Hochspannungsleitung (2) angeordnet sind, wobei jede Schalteinheit (3) ein Schaltelement (4) sowie einen in einer Parallelschaltung zum Schaltelement (4) angeordneten Überspannungsableiter (5) umfasst, dessen Schwellenspannung höher als eine Nennspannung des Schaltelementes (4) ist, wobei die Summe der Nennspannungen der Schaltelemente (4) mindestens einer Betriebsspannung der Hochspannungsleitung (2) entspricht,
wobei die Schaltelemente (4) mechanische Schalter sind, **dadurch gekennzeichnet, dass** jeder mechanische Schalter eine Kontaktanordnung mit zwei trennbaren Kontaktstücken umfasst und dazu eingerichtet ist, beim Trennen der Kontaktstücke eine Lichtbogenspannung aufzubauen, deren Betrag höher als die Nennspannung des mechanischen Schalters ist.

2. Vorrichtung (1,11) nach Anspruch 2,
**dadurch gekennzeichnet, dass**
die mechanischen Schalter zum Aufbau der Lichtbogenspannung jeweils wenigstens eine Lichtbogen-Löschkammer aufweisen.

3. Vorrichtung (1,11) nach einem der vorangehenden Ansprüche,
**dadurch gekennzeichnet, dass**
zum Auslösen der mechanischen Schalter wenigstens eine elektromagnetische Auslöseeinheit vorgesehen ist.

4. Vorrichtung (1,11) nach Anspruch 4,
**dadurch gekennzeichnet, dass** wenigstens eine Steuerungsvorrichtung (7) zur Ansteuerung der wenigstens einen Auslöseeinheit vorgesehen ist.

5. Vorrichtung (1,11) nach einem der vorangehenden Ansprüche,
**dadurch gekennzeichnet, dass**
die Nennspannung der mechanischen Schalter zwischen 1 kV und 20 kV beträgt.

6. Vorrichtung (1,11) nach einem der vorangehenden Ansprüche,
**dadurch gekennzeichnet, dass**
die Überspannungsableiter (5) Metalloxid-Varistoren sind.

7. Vorrichtung (1,11) nach einem der vorangehenden Ansprüche,
**dadurch gekennzeichnet, dass**
die Vorrichtung ferner einen Trennschalter (6) zum Unterbrechen des Gleichstromes umfasst, der in Reihe zu den Schalteinheiten (3) angeordnet ist.

8. Vorrichtung (1,11) nach einem der vorangehenden Ansprüche,
**dadurch gekennzeichnet, dass**
jede Schalteinheit (3) eine Stromanstieg begrenzende Induktivität aufweist, die in Reihe zum mechanischen Schalter angeordnet ist.

9. Vorrichtung (1,11) nach einem der vorangehenden Ansprüche,
**dadurch gekennzeichnet, dass**
die Vorrichtung ferner eine Messeinrichtung zum Detektieren eines Fehlerstromes in der Hochspannungsleitung umfasst und die Messeinrichtung mit der Steuerungsvorrichtung verbunden ist.

10. Verfahren zum Schalten eines Gleichstromes in einer Hochspannungsleitung (2), bei dem in einer Reihenschaltung angeordnete mechanische Schalter (4) ausgelöst werden, wobei in jedem mechanischen Schalter (4) eine Lichtbogenspannung aufgebaut wird, deren Betrag höher als eine Nennspannung des mechanischen Schalters (4) ist, so dass der Strom in einen parallel zu jedem mechanischen Schalter (4) angeordneten Parallelzweig mit mindestens einem Überspannungsableiter (5) kommutiert wird, dessen Schwellenspannung höher als die Nennspannung des mechanischen Schalters (4) ist.

## Claims

1. Apparatus (1, 11) for switching a direct current in a high-voltage line (2) with a large number of switching units (3) which are arranged to form a series circuit in the high-voltage line (2), wherein each switching unit (3) comprises a switching element (4) as well as a surge arrester (5) arranged in a circuit parallel with the switching element (4), the threshold voltage of said surge arrester being greater than a rated voltage of the switching element (4), wherein the sum of the rated voltages of the switching elements (4) corresponds to at least an operating voltage of the high-voltage line (2), wherein
the switching elements (4) are mechanical switches, **characterized in that** each mechanical switch comprises a contact arrangement with two separable contact pieces and is designed to develop an arcing voltage when the contact pieces are separated, the magnitude of which is greater than the rated voltage of the mechanical switch.

2. Apparatus (1, 11) according to Claim 1,
**characterized in that**
the mechanical switches each comprise at least one arc-extinguishing chamber to develop the arcing voltage.

3. Apparatus (1, 11) according to one of the previous claims, **characterized in that**
at least one electromagnetic trigger unit is provided to trigger the mechanical switches.

4. Apparatus (1, 11) according to Claim 3,
**characterized in that**
at least one control apparatus (7) is provided for driving the at least one trigger unit.

5. Apparatus (1, 11) according to one of the previous claims,
**characterized in that**
the rated voltage of the mechanical switches is between 1 kV and 20 kV.

6. Apparatus (1, 11) according to one of the previous claims,
**characterized in that**
the surge arresters (5) are metal oxide varistors.

7. Apparatus (1, 11) according to one of the previous claims,
**characterized in that**
the apparatus further comprises an isolating switch (6) for interrupting the direct current, which is arranged in series with the switching units (3).

8. Apparatus (1, 11) according to one of the previous claims,
**characterized in that**
each switching unit (3) comprises an inductor that limits the current rise and is arranged in series with the mechanical switch.

9. Apparatus (1, 11) according to one of the previous claims,
**characterized in that**
the apparatus further comprises a measuring device for detecting a fault current in the high-voltage line, and the measuring device is connected to the control apparatus.

10. Method for switching a direct current in a high-voltage line (2) in which mechanical switches (4) arranged in a series circuit are triggered, wherein an arcing voltage is developed in each mechanical switch (4), the magnitude of which is greater than a rated voltage of the mechanical switch (4), so that the current in a parallel branch arranged in parallel with each mechanical switch (4) is commuted with at least one surge arrester (5), whose threshold voltage is greater than the rated voltage of the mechanical switch (4).

## Revendications

1. Dispositif ( 1, 11 ) d'application d'un courant continu à une ligne ( 2 ) de haute tension, comprenant une pluralité d'unités ( 3 ) de coupure, qui sont montées dans la ligne ( 2 ) de haute tension avec formation d'un circuit série, chaque unité ( 3 ) de coupure comprenant un élément ( 4 ) de coupure, ainsi qu'un parafoudre ( 5 ), qui est monté suivant un circuit en parallèle avec l'élément ( 4 ) de coupure et dont la tension de seuil est plus haute qu'une tension nominale de l'élément ( 4 ) de coupure, la somme des tensions nominales des éléments ( 4 ) de coupure correspondant au moins à une tension de fonctionnement de la ligne ( 2 ) de haute tension, **caractérisé en ce que** les éléments ( 4 ) de coupure sont des interrupteurs mécaniques,
chaque interrupteur mécanique comprend un agencement de contact ayant deux pièces de contact séparables et est conçu pour, lorsque les pièces de contact sont séparées, établir une tension d'arc électrique plus haute que la tension nominale de l'interrupteur mécanique.

2. Dispositif ( 1, 11 ) suivant la revendication 1,
**caractérisé en ce que**
les interrupteurs mécaniques ont, pour l'établissement de la tension d'arc électrique, respectivement au moins une chambre d'extinction de l'arc électrique.

3. Dispositif ( 1, 11 ) suivant l'une des revendications précédentes,
**caractérisé en ce que**
une unité électromagnétique de déclenchement est prévue pour le déclenchement de l'interrupteur mécanique.

4. Dispositif ( 1, 11 ) suivant la revendication 3,
**caractérisé en ce qu'**au moins
un dispositif ( 7 ) de commande est prévu pour commander la au moins une unité de déclenchement.

5. Dispositif ( 1, 11 ) suivant l'une des revendications précédentes,
**caractérisé en ce que**
la tension nominale de l'interruption mécanique est comprise entre 1 kV et 20 kV.

6. Dispositif ( 1, 11 ) suivant l'une des revendications précédentes,
**caractérisé en ce que**
les parafoudres ( 5 ) sont des varistances à oxyde métallique.

7. Dispositif ( 1, 11 ) suivant l'une des revendications précédentes,
**caractérisé en ce que**
le dispositif comprend, en outre, un sectionneur ( 6 ) d'interruption du courant en continu, qui est monté en série avec des unités ( 3 ) de coupure.

8. Dispositif ( 1, 11 ) suivant l'une des revendications précédentes,
**caractérisé en ce que**
chaque unité ( 3 ) de coupure a une inductance, qui limite la montée du courant et qui est montée en série avec l'interrupteur mécanique.

9. Dispositif ( 1, 11 ) suivant l'une des revendications précédentes,
**caractérisé en ce que**
le dispositif comprend, en outre, un dispositif de mesure pour détecter un courant de fuite dans la ligne de haute tension et le dispositif de mesure est reliée au dispositif de commande.

10. Procédé d'application d'un courant continu à une ligne ( 2 ) de haute tension, dans lequel on déclenche des interrupteurs ( 4 ) mécaniques montés suivant un circuit en série, dans lequel on établit, dans chaque interrupteur ( 4 ) mécanique, une tension d'arc électrique plus haute qu'une tension nominale de l'interrupteur ( 4 ) mécanique, de manière à commuter le courant dans une branche parallèle montée en parallèle à chaque interrupteur ( 4 ) mécanique et ayant au moins un parafoudre ( 5 ), dont la tension de seuil est plus haute que la tension nominale de l'interrupteur ( 4 ) mécanique.
